# FASCICULE DE BREVET EUROPEEN

(11) **EP 1 928 645 B1**
(45) Date de publication et mention de la délivrance du brevet: **09.01.2013**
(21) Numéro de dépôt: 06820143.3
(22) Date de dépôt: 28.09.2006
(51) Int. Cl.: B29C 71/00, H01L 51/30, C08J 7/02, B82B 3/00, H01L 27/28, C23C 16/02

(54) **PROCEDE DE PREPARATION D'UNE SURFACE POLYMERE ORIENTEE ET NANOSTRUCTUREE**
VERFAHREN ZUR HERSTELLUNG EINER AUSGERICHTETEN UND NANOSTRUKTURIERTEN POLYMEROBERFLÄCHE
METHOD FOR PREPARING AN ORIENTED AND NANOSTRUCTURED SURFACE OF A POLYMER

(30) Priorité: 29.09.2005 FR 0509930
(43) Date de publication de la demande: 11.06.2008
(73) Titulaire: Centre National de la Recherche Scientifique, 75016 Paris (FR)
(72) Inventeur: BRINKMANN, Martin, F-67205 Oberhausbergen (FR); WITTMANN, Jean-Claude, F-67370 Pfluggriesheim (FR)
(74) Mandataire: Paris, Fabienne
(86) Numéro de dépôt international: PCT/FR2006/002201
(87) Numéro de publication internationale: WO 2007/036639

(56) Documents cités:
- EP-A- 1 241 209
- WO-A-02/50170
- US-A- 4 824 699
- US-A- 4 868 006
- US-A1- 2003 001 317
- US-A1- 2003 152 726
- I.LIEBERWIRTH, F.KATZENBERG, J.PETERMANN: "Nanostructured Polymer Films by Electron-Beam Irradiation and Selective Metallization" ADVANCED MATERIALS, vol. 10, no. 13, 27 avril 1998 (1998-04-27), pages 997-1001, XP002390871 cité dans la demande

## Description

La présente invention concerne un procédé de préparation d'un substrat dont au moins une surface est constituée par un polymère selon la revendication 1, un substrat de ce type selon la revendication 2, ainsi que différentes utilisations de ce substrat selon la revendication 16.

Le procédé selon l'invention est plus particulièrement destiné à préparer des substrats dont la surface est à la fois orientée, à l'échelle moléculaire, et nanostructurée, permettant d'y déposer de façon orientée des systèmes moléculaires et macromoléculaires variés. Ces substrats sont utiles notamment dans le domaine de l'optique, de l'éléctronique plastique, ou pour la fabrication de transistors à effet de champ.

On connaît déjà d'une part des méthodes permettant d'obtenir des surfaces polymères nanostructurées, et d'autre part des méthodes permettant de préparer des surfaces polymères orientées.

La nanostructuration de substrats polymères permet de contrôler des propriétés physiques et physico-chimiques de surfaces aussi diverses que les propriétés optiques anti-reflet, l'adhésion et l'orientation de protéines moteur ou les propriétés de mouillabilité et d'écoulement au voisinage d'une surface. Les méthodes de nanostructuration périodique de surfaces polymères font intervenir, pour la majorité d'entre elles, des copolymères à bloc (tel que décrit notamment dans la publication de Li et Yokohama, Adv. Mat.17, 2005, 1432). Les copolymères à bloc utilisés sont amorphes. Ce type de surface nanostructurée ne permet pas d'orienter les molécules ou macromolécules déposées sur le substrat.

La préparation de surfaces polymères orientées, permettant d'obtenir des surfaces importantes, de l'ordre de plusieurs cm², a été réalisée par trois méthodes.

Selon une première méthode, utilisée dans le domaine de l'affichage à cristaux liquides, des couches de polyimide à fort pouvoir orientant ont été obtenues par un procédé classique de brossage de surface qui induit une orientation superficielle des chaînes polymères (S. Steudel et al., Appl. Phys. Lett. 85, 2004, 4400). Cette méthode présente toutefois plusieurs inconvénients : la nécessité de recourir à un prépolymère pour des raisons de solubilité, l'usage de températures élevées (300°C) difficilement compatibles avec les contraintes associées à l'élaboration de dispositifs tout-polymère, et une rugosité élevée du substrat polymère qui est inadaptée à l'élaboration de dispositifs du type transistors organiques à effet de champ.

Selon une deuxième méthode, décrite dans US 5 731 405, on réalise une irradiation par UV-polarisé de films polyimide ou de matériaux polymère liquides cristallins qui nécessite la synthèse de polymères à caractère liquide cristallin. Le principal inconvénient de cette méthode réside dans le fait que la nature chimique de la surface polymère peut être fortement modifiée par l'irradiation UV, et ce de manière non contrôlée.

Selon une troisième méthode, décrite par Wittmann et al., Nature 352, 414-417 (1991), des films orientés de poly-(tétrafluoroéthylène) (PTFE) sont fabriqués par une technique de transfert par friction d'un barreau de PTFE sur une surface plane. Cette méthode permet d'obtenir des films cristallins de PTFE d'épaisseur inférieure à 100 nm sur différents substrats, et les films obtenus permettent d'orienter un grand nombre de systèmes moléculaires et polymères. Toutefois, cette méthode présente des inconvénients majeurs : un problème de reproductibilité lié au contrôle difficile du taux de couverture en PTFE, et la discontinuité des films polymères obtenus ainsi que leur relativement forte rugosité (relief de surface de l'ordre de 30 nm).

On connaît également une méthode de préparation de surfaces polymères orientées et nanostructurées (appelées SPONs) (J. Petermann et al., J. Mater Sci., 14, 1979, 2000 et I. Lieberwirth et al., Adv. Mat. 110, 1998, 997). Cette méthode consiste à orienter un film polymère fondu sans support par étirement à chaud puis cristallisation lors du refroidissement. Les inconvénients de cette méthode sont liés d'une part à la difficulté de produire des films orientés sur un substrat donné, et d'autre part à l'impossibilité de contrôler précisément l'épaisseur des films, ce qui est indispensable si l'on cherche par exemple à utiliser le substrat polymère comme isolant de grille dans une architecture de type transistor organique à effet de champ. En effet, on sait que le transport de charges optimal dans une telle structure se fait au niveau des premières couches moléculaires en contact avec le diélectrique.

Le document WO-A-02/50170 décrit un procédé pour contrôler la morphologie de la surface d'un polymère.

Pour remédier à l'ensemble de ces inconvénients, l'invention propose un procédé permettant de préparer un substrat dont la surface, qui est constituée par un film de polymère, est à la fois orientée et nanostructurée, tout en contrôlant la rugosité de cette surface. En outre, ce procédé permet d'obtenir des substrats dont l'orientation et la structure demeurent stables pendant plusieurs heures, même à des températures élevées de l'ordre de 130°C.

Ce procédé présente également l'avantage d'être simple à mettre en oeuvre, puisque la préparation du substrat peut être réalisée à température ambiante, et d'être reproductible, donc bien adapté à une mise en oeuvre à l'échelle industrielle.

A cet effet, selon un premier aspect, l'invention propose un procédé de préparation d'un substrat dont au moins une surface est constituée par un polymère, ladite surface de polymère étant orientée et nanostructurée, ledit procédé comprenant les étapes successives suivantes :
a) brossage de la surface polymère à l'état amorphe du substrat ;
b) mise en contact avec une vapeur d'un solvant, de la surface de polymère orienté obtenue à la fin de l'étape a), ledit solvant étant choisi de sorte que :
   - | δ_{poly} - δₛₒₗ | / [ (δ_{poly} + δₛₒₗ) / 2] < 0, 3, δ_{poly} et δₛₒₗ représentant respectivement les paramètres de solubilité du polymère et du solvant, et ;
   - γₛₒₗ < γ_{poly}, γₛₒₗ et γ_{poly} représentant respectivement les énergies libres de surface du solvant et du polymère.

L'étape a) permet d'orienter en surface les macromolécules du polymère dans une même direction, et l'étape b) permet de provoquer une cristallisation partielle du polymère, qui entraîne une nanostructuration de surface et modifie la rugosité de la surface résultant de l'étape a) de brossage.

- L'étape b) peut être réalisée avec des mélanges de solvants.

Les valeurs des constantes ou des paramètres de solubilité d'une large gamme de solvants et de polymères sont publiées dans la littérature, notamment dans US 4 529 563 et dans la publication de A.F.M. Barton, Chem. Rev., 75, n°6, 731, 1975.

Selon une réalisation, le substrat est constitué par ledit polymère, c'est-à-dire que le substrat est une pièce massive de polymère dont au moins une surface est traitée par le procédé selon l'invention.

Selon une autre réalisation, le substrat est constitué par un support formé d'un matériau chimiquement inerte, dont au moins une surface est revêtue d'un film de polymère. Le film polymère peut être déposé par diverses méthodes, par exemple par dépôt à la tournette, à l'aide d'une balayette, par extrusion du film polymère, ou autres. Le film de polymère déposé est typiquement d'épaisseur comprise entre 50 nm et plusieurs microns.

Le support utilisé peut être une lame de verre, un wafer de silicium, un verre conducteur ITO (Indium Tin Oxide), une surface métallique.

Dans tous les cas, il est nécessaire que le support ne soit pas altéré par le procédé de dépôt du film polymère amorphe.

Le polymère utilisé doit exister sous forme amorphe et sous forme semi-cristalline. Il est de préférence choisi dans le groupe comprenant les polyesters (polycarbonates, polycarbonates fluorés, polyéthylène téréphtalate et polyéthylène naphtalate, acide polylactique), et le polystyrène isotactique.

Lorsque le polymère utilisé est le polycarbonate de bisphénol A, le solvant peut être choisi dans le groupe constitué par l'acétone, le toluène, le chloro-benzène, le tétrahydrofurane et la cyclohexanone.

Lorsque le polymère utilisé est le polystyrène isotactique, le solvant peut être l'acétone.

Le procédé selon l'invention peut comprendre une étape préliminaire pour la détermination des conditions nécessaires pour l'obtention d'une rugosité donnée de la surface polymère après l'étape b).

Selon une première variante, cette étape préliminaire comprend :
- la mise en oeuvre de l'étape a) pour une série de substrats identiques dans des conditions identiques ;
- la mise en oeuvre de l'étape b) pour chaque substrat obtenu à la fin de l'étape a), à l'aide du même solvant, à la même température, en faisant varier la durée du traitement d'un substrat à l'autre ;
- la détermination de la rugosité obtenue à la surface de chaque substrat après l'étape b) ;
- l'identification des conditions de mise en oeuvre aboutissant à la rugosité souhaitée.

La durée d'exposition du film brossé aux vapeurs de solvant dépend de la constante de diffusion d'un solvant donné dans un polymère donné ; elle est donc spécifique à chaque couple polymère/solvant. Cette durée est généralement comprise entre 1 minute et 30 minutes.

Si le temps nécessaire pour atteindre la valeur de rugosité souhaitée est trop court, on peut prévoir d'utiliser un mélange de vapeur de solvant et d'air ou d'un gaz inerte, de manière à ralentir le processus de cristallisation.

A l'inverse, la durée de traitement peut être réduite en augmentant la température durant l'exposition du film à la vapeur de solvant.

Selon une deuxième variante, cette étape préliminaire comprend :
- la mise en oeuvre de l'étape a) pour une série de substrats identiques dans des conditions identiques ;
- la mise en oeuvre de l'étape b) pour chaque substrat obtenu à la fin de l'étape a), à l'aide du même solvant, pendant la même durée, en faisant varier la température du traitement d'un substrat à l'autre ;
- la détermination de la rugosité obtenue à la surface de chaque substrat après l'étape b) ;
- l'identification des conditions de mise en oeuvre aboutissant à la rugosité souhaitée.

Après mise en oeuvre de l'étape préliminaire, le procédé selon l'invention comprend la mise en oeuvre des étapes a) et b) dans les conditions identifiées à la fin de l'étape préliminaire.

L'homme du métier pourra donc, par des essais de routine, déterminer les conditions de température et de durée à mettre en oeuvre lors de l'étape b) pour obtenir un substrat dont la rugosité correspond à l'application recherchée.

Selon un deuxième aspect, l'invention a pour objet un substrat constitué par un support formé d'un matériau chimiquement inerte dont au moins une surface est revêtue d'un film de polymère, ladite surface étant orientée et nanostructurée, et ladite surface présentant une structure périodique comprenant une alternance de zones amorphes et de lamelles cristallines, la périodicité caractéristique associée à une séquence lamelle cristalline / zone amorphe étant comprise entre 5 et 100 nm.

Ledit support formé d'un matériau chimiquement inerte peut être une lame de verre, un wafer de silicium, un verre conducteur ITO (Indium Tin Oxide) ou une surface métallique.

L'invention a également pour objet l'utilisation d'un substrat selon l'invention pour le dépôt orienté de semi-conducteurs organiques (moléculaires et polymères) tels que le pentacène, la phtalocyanine de zinc, le coronène, ou de colorants organiques, ou de particules colloïdales, par exemple des particules d'or.

Ce dépôt est réalisé de préférence en formant un film des molécules ou macromolécules sur le substrat, par sublimation sous vide ou par dépôt à partir d'une solution dans un solvant qui n'affecte pas la structure du substrat, le substrat étant maintenu à une température constante comprise entre 25°C et 130°C.

La présente invention est illustrée ci-après par des exemples concrets de réalisation, auxquels elle n'est cependant pas limitée. Les exemples 1 à 3 portent sur la préparation et la caractérisation de substrats selon l'invention, et les exemples 4 à 7 portent sur l'utilisation de l'un de ces substrats pour le dépôt orienté de diverses molécules.

### Exemple 1

Cet exemple porte sur la préparation d'un substrat dont une surface est revêtue d'un film de polycarbonate de bisphénol A, le solvant utilisé pour la cristallisation étant l'acétone.

On prépare une solution à 2% en masse d'un polycarbonate commercial (commercialisé par la société Acros, avec Mw = 64000) dans le dichlorométhane.

Un film de polycarbonate amorphe est ensuite préparé par dépôt à la tournette sur des lames de verre propre (référence Corning 2947) à 2000 tours/min.

Pour la mise en oeuvre de l'étape de brossage, on utilise un appareil fabriqué selon un modèle décrit dans la publication de Becker et al., Mol. Cryst. & Liq. Cryst., 132, 167, 1986.

Un cylindre métallique (diamètre 40 mm) recouvert d'un tissu de velours (polyamide ou coton) est appliqué sur le film polymère par un piston exerçant une pression de 2 bars. Lors de la mise en contact du rouleau avec l'échantillon de polymère, le cylindre tourne à une vitesse de 100-300 tours/min., et l'échantillon est translaté à une vitesse constante de 1 cm/s. La longueur de brossage est de l'ordre de 200 cm. Le film brossé de polycarbonate est ensuite exposé à un jet d'azote.

Après brossage, le film présente une forte biréfringence optique.

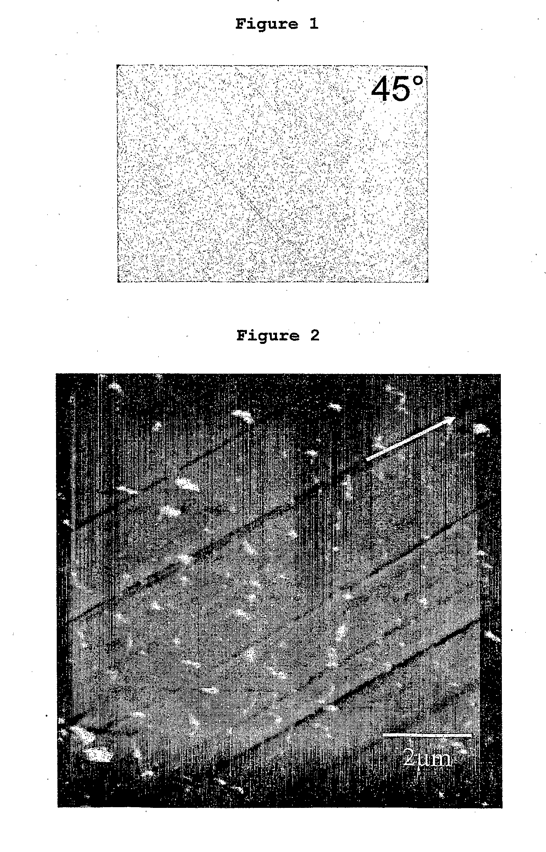

Les figures 1 et 2 sont des clichés d'un film obtenu après brossage, réalisés par microscopie à force atomique, à deux échelles différentes. On constate que la surface présente des sillons.

La forte biréfringence optique traduit à la fois la présence des sillons orientés dans la direction du brossage (biréfringence de forme) et l'orientation préférentielle des chaînes de polymère en surface. Les chaînes de polymère ne sont orientées qu'en surface, sur une profondeur de quelques nanomètres.

La présence de sillons conduit à une rugosité importante, de l'ordre de 5 nm (RMS), la rugosité étant mesurée par microscopie à force atomique (Tapping mode) avec un appareil Nanoscope III muni de pointes Si (25-50 N/m, 280-365 kHz) sur des surfaces de 2x2 µm².

A ce stade, les films brossés n'induisent aucune orientation moléculaire significative des matériaux déposés.

Pour la mise en oeuvre de la deuxième étape du procédé, le film brossé de polymère est exposé à des vapeurs d'acétone dans une enceinte en verre fermée et maintenue à température constante (20-25°C) en présence d'air. Dans ces conditions, la pression partielle de vapeur d'acétone est de l'ordre de 250 mbar.

L'exposition du film brossé à des vapeurs d'acétone à température ambiante provoque d'une part la cristallisation orientée du film, qui entraîne une nanostructuration de surface, et d'autre part une réduction significative de la rugosité induite par brossage, étant entendu que la valeur de rugosité obtenue dépend de la durée d'exposition aux vapeurs d'acétone.

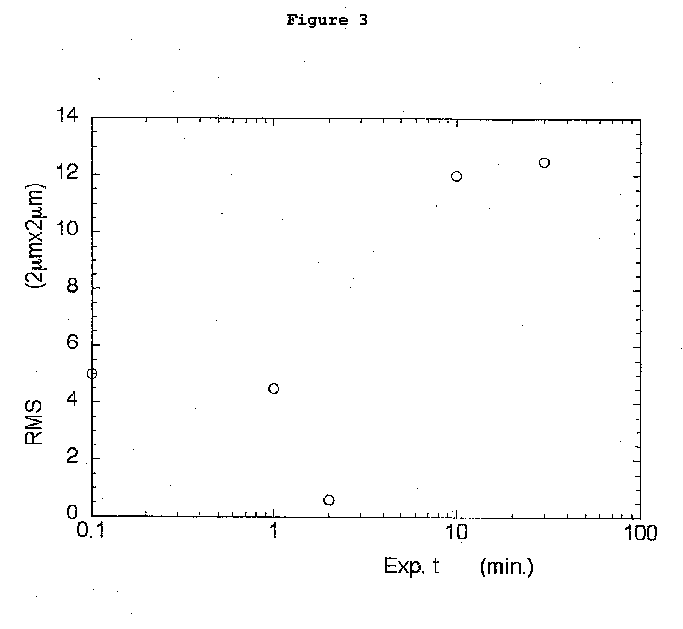

Les résultats obtenus sont présentés sur la (figure 3, qui est une courbe représentant la rugosité mesurée en fonction du temps d'exposition t, en minutes. On constate qu'il existe un temps d'exposition optimal pour obtenir à la fois une rugosité minimale du film, un degré d'orientation important et une nanostructuration de surface. Cette valeur minimale de la rugosité, égale à 0,5 nm, est obtenue pour un temps d'exposition de 2 minutes. Cette faible valeur est particulièrement requise pour certaines applications, telles que la fabrication de transistors à effet de champ.

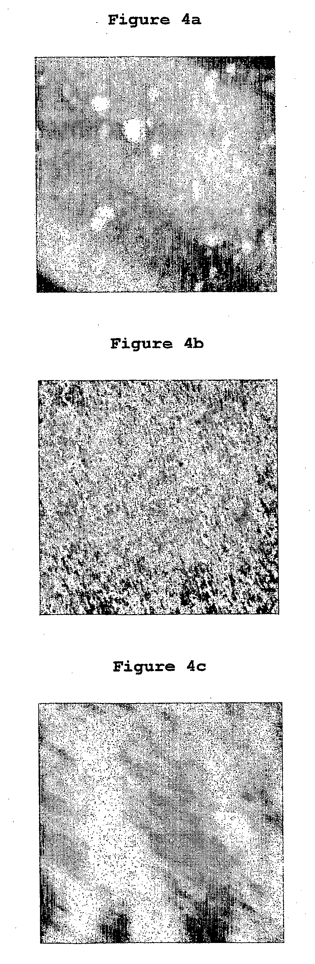

Les figures 4a-c sont des images de topographie réalisées par microscopie à force atomique, représentant la surface du film après un temps d'exposition aux vapeurs d'acétone respectivement égal à 1 minute, 2 minutes et 30 minutes. La rugosité mesurée est respectivement de 4-5 nm (figure 4a), 0,5 nm (figure 4b) et 12 nm (figure 4c).

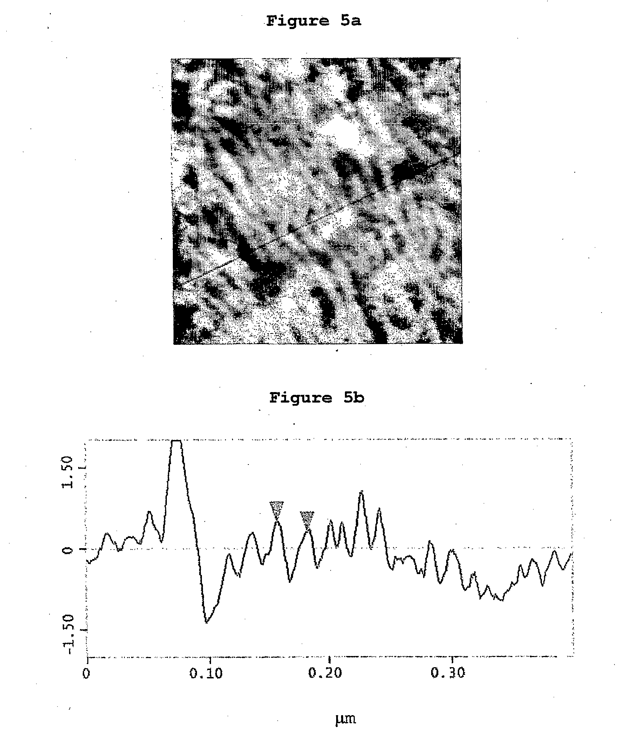

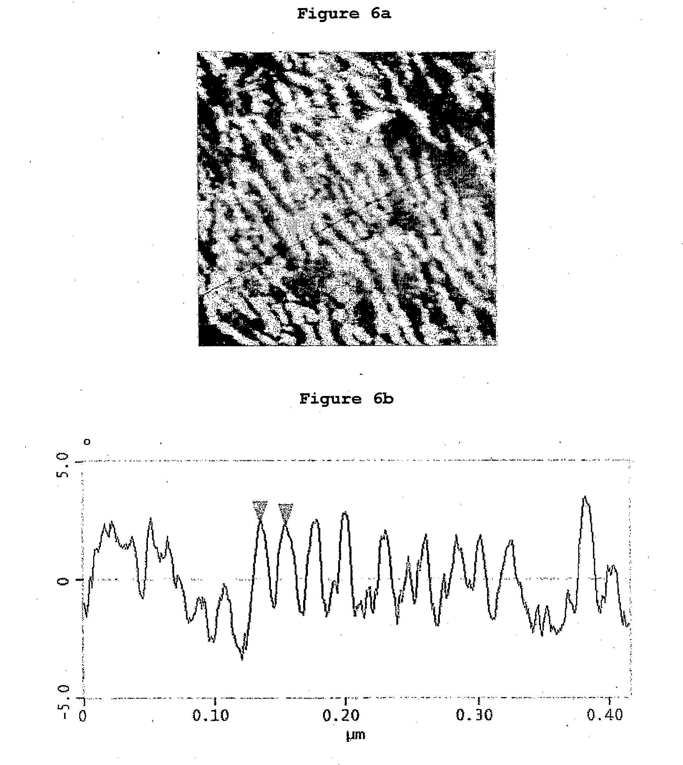

La nanostructuration de surface résulte de l'alternance de domaines cristallins et amorphes, qui ressort des figures 5a-b (correspondant à une image obtenue en mode topographie) et 6a-b (correspondant à une image en mode contraste de phase) qui mettent en évidence l'existence d'une alternance de domaines cristallins et amorphes à travers l'existence d'un contraste de phase. Il est connu que des zones cristallines et amorphes d'un polymère présentent des réponses viscoélastiques différentes donnant lieu au contraste de phase observé en microscopie à force atomique (S. S. Sheiko, Advances in Polymer Sciences vol 151, Springer Verlag, Berlin-Heidelberg, 2000). Il apparaît que la périodicité totale est de l'ordre de 20±4 nm.

### Exemple 2

Un substrat dont une surface est revêtue d'un film de polystyrène isotactique a été préparé, le solvant utilisé pour la cristallisation étant l'acétone.

Les conditions de préparation du substrat sont similaires à celles décrites dans l'exemple 1, avec une longueur de brossage égale à 50 cm. Le film brossé de polymère a été exposé à des vapeurs d'acétone pendant 2 minutes, à une température de 23°C.

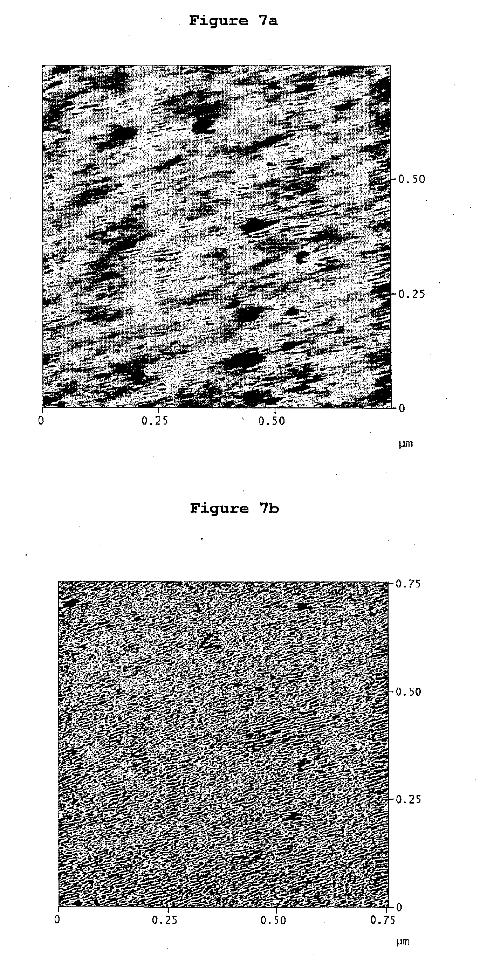

Le résultat obtenu est représenté sur les figures 7a (image de topographie) et 7b (image en contraste de phase), qui mettent en évidence l'existence d'une alternance de domaines cristallins et amorphes.

### Exemple 3

Cet exemple porte sur la préparation et la caractérisation d'un substrat de Si(100) dont une surface est revêtue d'un film de polycarbonate.

### Préparation

Le substrat de Si(100) utilisé est commercialisé par Silchem sous la référence 4S41/90, et présente les caractéristiques suivantes : wafer de diamètre 100 mm, résistivité 53,5 Ohm/cm, épaisseur 460 microns.

On prépare une solution de polycarbonate de bisphénol A (commercialisé par Acros, Mw = 64000), dans le tétrachloroéthane, à une concentration de 2% en masse.

Le dépôt à la tournette se fait à 2000 rpm et une accélération de 2000 rpm/s. Les substrats de Si(100) ont une dimension typique de de 8 cm x 2,5 cm. Après dépôt à la tournette, les films sont placés dans une étuve sous vide à température ambiante pendant une durée comprise entre 30 minutes et 1 heure, afin d'éliminer toute trace de tétrachloroéthane. En effet, ce solvant possède une température d'ébullition élevée et sa présence dans les films peut altérer l'efficacité de la cristallisation par vapeur d'acétone.

Les autres étapes de la préparation sont identiques à celles décrites dans l'exemple 1.

L'épaisseur des films minces de polycarbonate est de l'ordre de 300 nm.

### Caractérisation

Les expériences décrites aux points a) et b) ont pour but d'étudier la structure et l'orientation des films de polycarbonate en fonction de leur durée d'exposition à la vapeur de solvant et de leur profondeur.

Ces expériences ont été réalisées en utilisant un rayonnement synchrotron.

### a) Structure et orientation des films en fonction de leur durée d'exposition à la vapeur de solvant

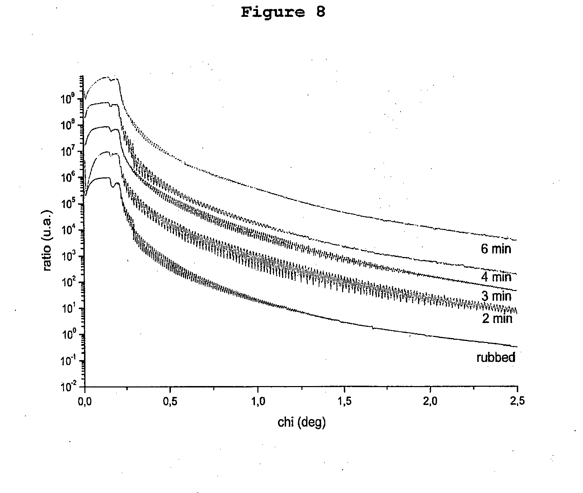

Les expériences ont été réalisées sur 5 échantillons différents correspondant à des temps d'exposition à une vapeur d'acétone respectivement de 0, 2, 3, 4 et 6 minutes. La figure 8 reflète l'évolution de la réflectivité spéculaire en fonction du temps d'exposition à la vapeur d'acétone.

L'atténuation des franges de Kiessig est liée à la rugosité des films. Pour un temps d'exposition de 2 minutes, la quasi-absence d'amortissement des oscillations indique que la surface est extrêmement peu rugueuse. Pour des temps d'exposition supérieurs à 3 minutes, on observe que les oscillations sont de plus en plus amorties, ce qui signifie que la rugosité des films augmente avec la durée d'exposition à la vapeur d'acétone, et que la cristallisation du polycarbonate se propage vers l'intérieur du film polymère.

### b) Structure et orientation des films en fonction de leur profondeur

Par des mesures de diffraction de rayons X en incidence rasante, il a été possible d'étudier la structure des films en fonction de leur profondeur. L'angle critique de réflection critique est de l'ordre de χ_{c} = 0,15 deg. On en déduit des profondeurs de pénétration des rayons X de l'ordre de 6 nm pour χ = 0,10 deg., et de 60 nm pour χ = 0,15 deg. Pour χ = 0,18 deg, la profondeur de pénétration dépasse l'épaisseur du film polymère.

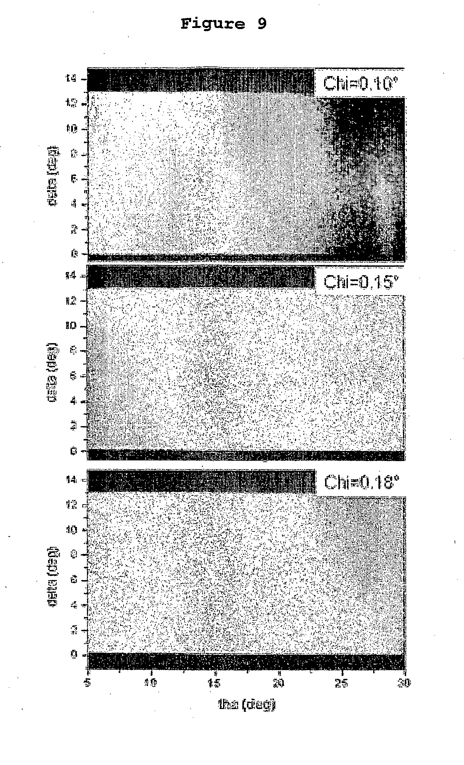

La figure 9 représente l'évolution du diagramme de rayons X en incidence rasante en fonction de l'angle d'incidence χ pour le film de polycarbonate orienté et nanostructuré. Les diagrammes sont obtenus à l'aide d'un détecteur PSD orienté perpendiculairement au plan du film en géométrie (θ, 2θ), l'orientation θ=0 est telle que le faisceau incident est parallèle à la direction de brossage des films polymères.

Ces expériences ont permis d'identifier un certain nombre de taches de diffraction du type (hk0). Les résultats de la figure 9 montrent l'existence de zones cristallisées et orientées en surface (χ = 0,10 deg et 0,15 deg), alors que l'intérieur du film est amorphe comme l'indique la présence d'un halo amorphe (χ = 0,18 deg). La réflection observée pour 2θ_{B} = 15,5 deg est attribuée à la réflection (210) de la structure monoclinique du polycarbonate (d'après R. Bonart, Die Makromoleculare Chemie, 92, 149 (1966)).

Par ailleurs, ces expériences permettent de mesurer la dispersion angulaire dans le plan du substrat de l'orientation des lamelles cristallisées de polycarbonate (Δω ≈ 25 deg (demi-largeur à mi-hauteur)).

L'ensemble des résultats de la figure 9 permet également de montrer que la surface des lamelles cristallines de polycarbonate correspond à de plans denses du type (010). Ce résultat est inattendu étant donné que des méthodes de brossage classique conduisent à des films polymères orientés ayant une symétrie de fibre (système uniaxial) alors que le système selon l'invention présente une orientation biaxiale.

On décrit à présent plusieurs exemples d'application du substrat de polycarbonate dont la fabrication a été décrite dans l'exemple 1.

Dans ces exemples, les films organiques de pentacène, de phtalocyanine de zinc et de colorants diazo ainsi que les films d'or sont préparés par sublimation sous vide sur le substrat de polycarbonate maintenu à une température constante comprise entre 25°C et 130°C.

La fabrication d'un film par évaporation sous vide se fait typiquement en utilisant un évaporateur commercial du type Auto 306 (BOC Edwards). Le vide secondaire utilisé se situe dans la gamme 10⁻⁵ - 10⁻⁷ mbar.

Lorsque le produit à déposer est un matériau organique, la source d'évaporation est constituée d'un creuset en quartz contenant le produit à déposer. Le creuset est chauffé résistivement par un filament en tungstène. Une balance à quartz permet de mesurer la vitesse de dépôt (en nm/min) ainsi que l'épaisseur des films. Le substrat orienté de polymère est placé sur un porte-échantillon qui peut être chauffé, situé à une distance comprise entre 10 cm et 30 cm de la source.

La température de chauffage du creuset est augmentée jusqu'à ce que la vitesse de dépôt souhaitée (entre 1 et 10 nm/min) soit atteinte. Un masque situé devant le substrat est alors retiré afin de démarrer le dépôt sur le substrat. Lorsque l'épaisseur souhaitée est atteinte, le masque est replacé devant l'échantillon. Ce dernier est sorti de l'évaporateur uniquement lorsque la température du substrat est revenue à une température proche de la température ambiante.

Pour le dépôt de l'or, on utilise généralement comme source un simple fil de tungstène chauffé résistivement autour duquel on enroule un morceau de fil d'or à évaporer (1 cm environ de longueur, 25 microns de diamètre).

### Exemple 4 : dépôt orienté de pentacène

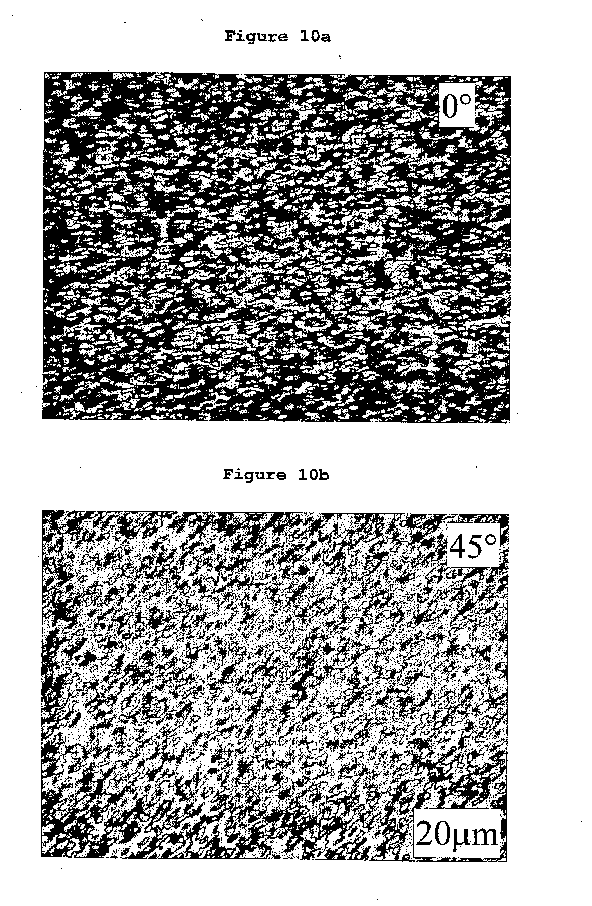

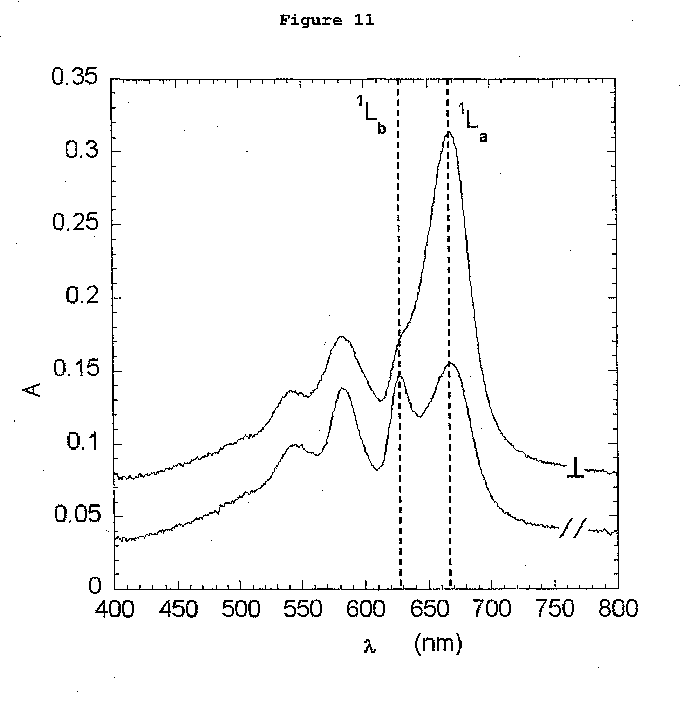

Cette molécule est un semi-conducteur organique utilisé pour la fabrication de transistors à effet de champ. Les clichés de microscopie optique (figures 10a et 10b) et la courbe représentant l'absorbance A en fonction de la longueur d'onde lambda, en nanomètres, (figure 11) font apparaître respectivement une biréfringence élevée ainsi qu'une forte anisotropie de l'absorption optique. Ces résultats impliquent un degré d'orientation élevé des molécules sur le substrat, qui est semblable à celui obtenu pour des substrats de PTFE orienté (cf M. Brinkmann et al., J. Phys. Chem. B 107, 10531, 2003).

### Exemple 5 : dépôt orienté de la phtalocyanine de zinc.

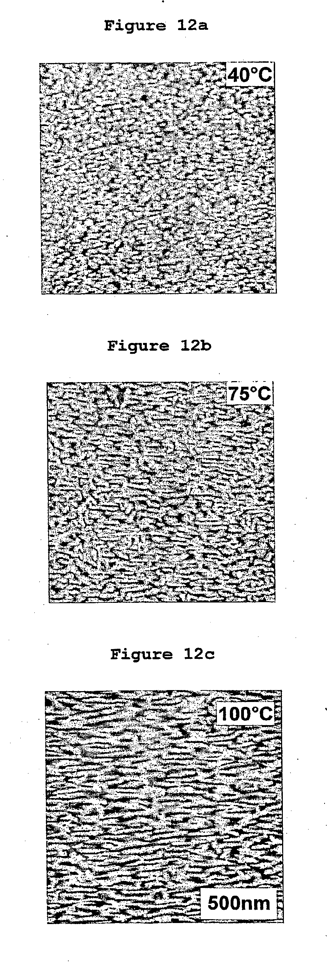

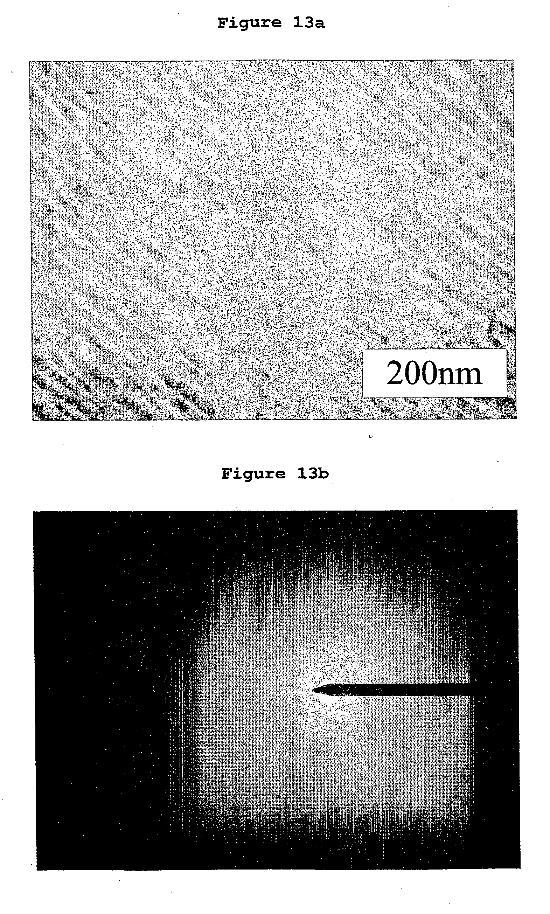

Les figures 12a-c représentent des images topographiques obtenues par microscopie à force atomique de films minces de phtalocyanine de zinc ZnPc (50 nm) déposés sur un substrat de polycarbonate orienté pour des températures de dépôt respectives de 40°C, 75°C et 100°C. Les figures 13a-b présentent respectivement une image en champ clair ainsi que le cliché de diffraction correspondant pour un film de phthalocyanine d'épaisseur 50 nm et déposé à une température du substrat Ts de 100°C. Les résultats obtenus font ressortir que le degré d'orientation de la phtalocyanine de zinc augmente avec la température du substrat, et que l'orientation du substrat est maintenue jusqu'à une température de 100°C. Des expériences complémentaires ont montré que le pouvoir orientant des substrats est maintenu au moins jusqu'à Ts=130°C.

L'analyse par microscopie électronique du degré d'orientation fait apparaître la présence de cristaux allongés de phtalocyanine de zinc (figure 13a) et l'obtention de taches de diffraction très fines (figure 13b), présentant une uniformité sur toute la surface.

### Exemple 6 : dépôt orienté de coronène

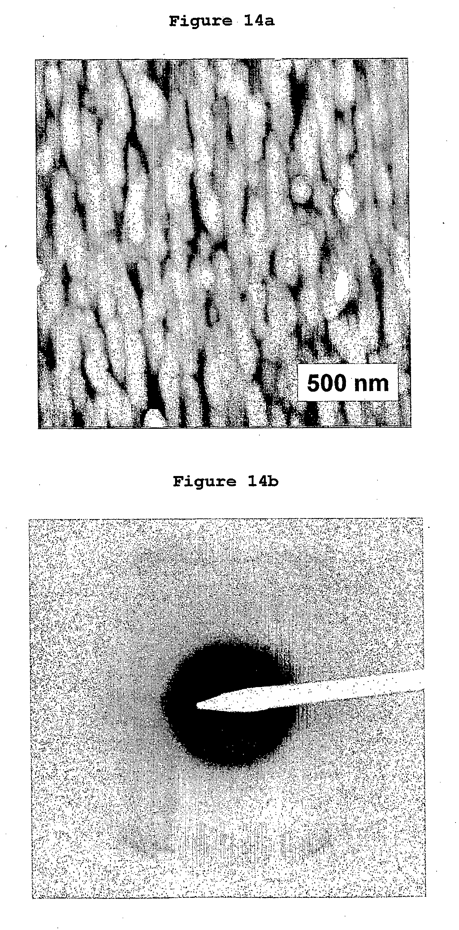

L'image topographique (figure 14a) obtenue par microscopie à force atomique d'un film mince de coronène (50 nm) déposé sur un substrat de polycarbonate orienté, à une température de substrat Ts = 29°C, montre une surface constituée de cristaux orientés alors que le cliché de diffraction correspondant (figure 14b) présente des taches de diffraction légèrement arquées, démontrant un fort degré d'orientation semblable à celui observé pour la phthalocyanine.

### Exemple 7 : dépôt orienté de nanoparticules d'or

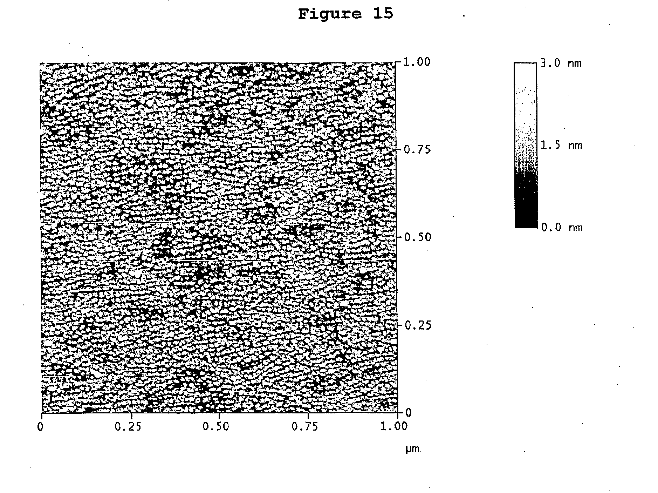

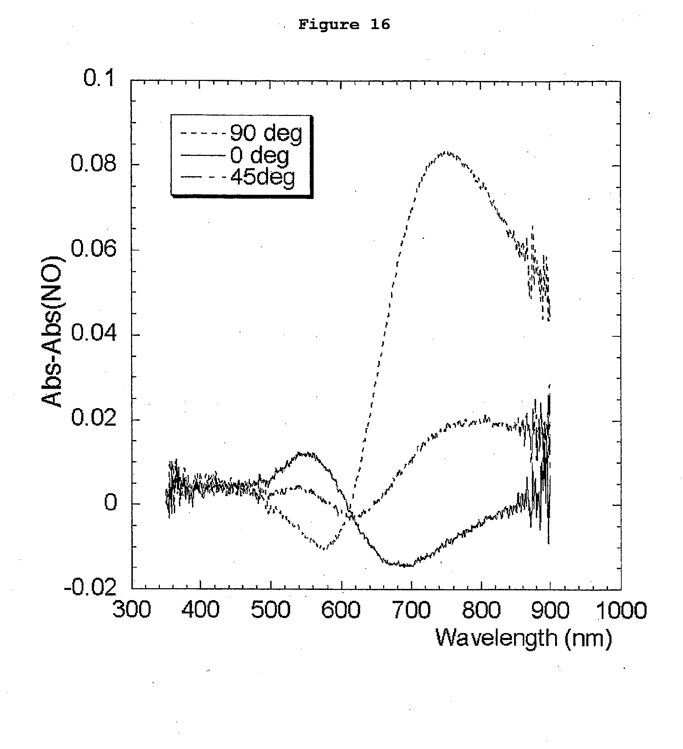

Le dépôt d'environ 10 nanomètres d'or par évaporation sur un substrat orienté et nanostructuré de polycarbonate donne lieu à la formation de nanoparticules d'or avec une distribution de taille relativement étroite. Par microscopie à force atomique (figure 15), on observe un alignement plus ou moins marqué des nanoparticules par la surface nanostructurée du substrat. L'absorption optique de ces films est polarisée et présente un maximum d'absorption vers 700 nm lorsque la polarisation de l'onde incidente est orientée perpendiculairement à la direction de brossage des substrats de polycarbonate (figure 16, représentant l'absorbance en fonction de la longueur d'onde lambda, en nanomètres). A noter que l'absorption optique a été mesurée en prenant comme référence un film d'or sur PC non orienté.

### Exemple 8 : dépôt orienté de colorants azo

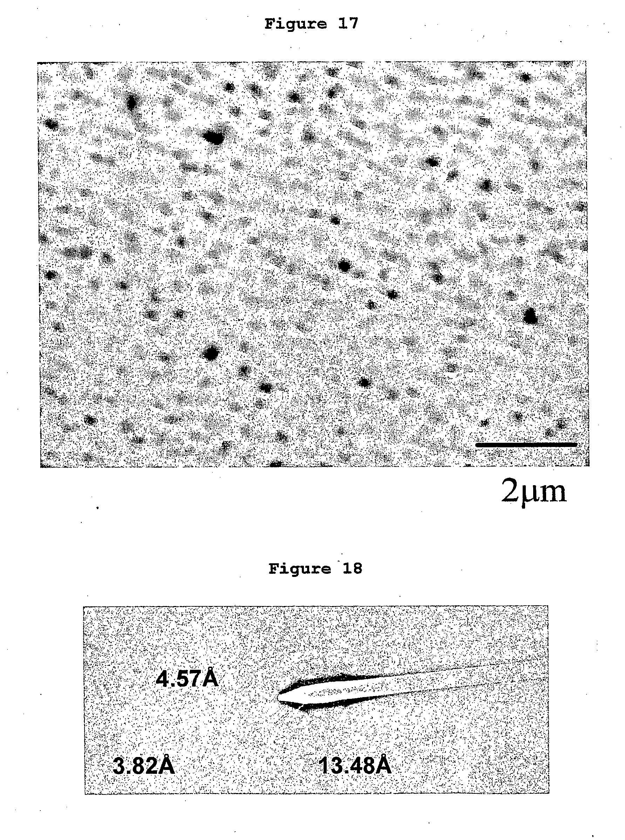

L'image en champ clair obtenue par microscopie électronique en transmission d'un film mince (50 nm) de colorant diazo de formule (I) ci-dessous déposé sur un substrat de polycarbonate orienté, à une température de substrat Ts = 29°C, est présentée sur la figure 17.

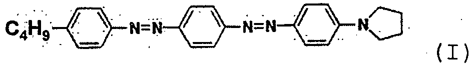

Pour ce film, on observe par mesure d'absorption polarisée une anisotropie très importante de l'absorption optique. Le maximum d'absorption est obtenu lorsque la polarisation de l'onde incidente est orientée perpendiculairement à la direction de brossage. Le rapport dichroïque défini par le rapport d'absorption perpendiculaire sur l'absorption parallèle, mesurée à 560 nm, atteint aisément une valeur de l'ordre de 20. Les mesures de diffraction électronique montrent un cliché de diffraction présentant des taches légèrement arquées (figure 18), démontrant un fort degré d'orientation des films.

## Revendications

1. Procédé de préparation d'un substrat dont au moins une surface est constituée par un polymère, ladite surface de polymère étant orientées et nanostructurée, ledit procédé étant **caractérisé en ce qu'**il comprend les étapes successives suivantes :
a) brossage de la surface polymère à l'état amorphe du substrat ;
b) mise en contact avec une vapeur d'un solvant, de la surface de polymère orienté obtenue à la fin de l'étape a), ledit solvant étant choisi de sorte que :
- | δ_{poly} - δₛₒₗ | / [ (δ_{poly} + δₛₒₗ) / 2] < 0,3, δ_{poly} et δₛₒₗ représentant respectivement les paramètres de solubilité du polymère et du solvant, et ;
- γₛₒₗ < γ_{poly}, γₛₒₗ et γ_{poly} représentant respectivement les énergies libres de surface du solvant et du polymère.

2. Procédé selon la revendication 1, **caractérisé en ce que** le substrat est constitué par ledit polymère.

3. Procédé selon la revendication 1, **caractérisé en ce que** le substrat est constitué par un support dont au moins une surface est revêtue d'un film de polymère, ledit support étant formé d'un matériau qui n'est pas altéré par le procédé de dépôt du film de polymère.

4. Procédé selon la revendication 3, **caractérisé en ce que** le film de polymère est d'épaisseur comprise entre 50 nanomètres et plusieurs microns.

5. Procédé selon l'une quelconque des revendications 1. à 4, **caractérisé en ce que** ledit polymère est choisi dans le groupe comprenant les polyesters tels que les polycarbonates, les polycarbonates fluorés, le polyéthylène téréphtalate et le polyéthylène naphtalate, l'acide polylactique, et le polystyrène isotactique.

6. Procédé selon la revendication 5, **caractérisé en ce que** le polymère est le polycarbonate de bisphénol A.

7. Procédé selon la revendication 1, **caractérisé en ce que** le polymère est le polycarbonate de bisphénol A et le solvant est choisi dans le groupe constitué par l'acétone, le toluène, le chlorobenzène, le tétrahydrofurane et la cyclohexanone.

8. Procédé selon la revendication 1, **caractérisé en ce que** ledit polymère est choisi dans le groupe comprenant les polyesters tels que les polycarbonates (bisphénol A), le polyéthylène téréphtalate et naphtalate, l'acide polylactique, et le polystyrène isotactique, et **en ce que** le solvant est l'acétone.

9. Procédé selon la revendication 1, **caractérisé en ce que** le polymère est le polystyrène isotactique et le solvant est l'acétone.

10. Procédé selon la revendication 1, **caractérisé en ce qu'**il comprend une étape préliminaire pour la détermination des conditions nécessaires pour l'obtention d'une rugosité donnée de la surface polymère après l'étape b).

11. Procédé selon la revendication 10, **caractérisé en ce que** l'étape préliminaire comprend :
- la mise en oeuvre de l'étape a) pour une série de substrats identiques dans des conditions identiques ;
- la mise en oeuvre de l'étape b) pour chaque substrat obtenu à la fin de l'étape a), à l'aide du même solvant, à la même température, en faisant varier la durée du traitement d'un substrat à l'autre ;
- la détermination de la rugosité obtenue à la surface de chaque substrat après l'étape b) ;
- l'identification des conditions de mise en oeuvre aboutissant à la rugosité souhaitée.

12. Procédé selon la revendication 10, **caractérisé en ce que** l'étape préliminaire comprend :
- la mise en oeuvre de l'étape a) pour une série de substrats identiques dans des conditions identiques ;
- la mise en oeuvre de l'étape b) pour chaque substrat obtenu à la fin de l'étape a), à l'aide du même solvant, pendant la même durée, en faisant varier la température du traitement d'un substrat à l'autre ;
- la détermination de la rugosité obtenue à la surface chaque substrat après l'étape b) ;
- l'identification des conditions de mise en oeuvre aboutissant à la rugosité souhaitée.

13. Procédé selon l'une des revendications 11 ou 12, **caractérisé en ce que**, après la mise en oeuvre de l'étape préliminaire, on effectue les étapes a) et b) dans les conditions identifiées à la fin de l'étape préliminaire.

14. Substrat constitué par un support dont au moins une surface est revêtue d'un film de polymère, ledit support étant formé d'un matériau qui n'est pas altéré par le procédé de dépôt du film de polymère, et ladite surface étant orientée et nanostructurée, **caractérisé en ce que** ladite surface présente une structure périodique comprenant une alternance de zones amorphes et de lamelles cristallines, la périodicité associée à une séquence lamelle cristalline / zone amorphe étant comprise entre 5 et 100 nm.

15. Substrat selon la revendication 14, **caractérisé en ce que** ledit support est une lame de verre, un wafer de silicium, un verre conducteur ou une surface métallique.

16. Utilisation d'un substrat selon la revendication 14 ou 15 pour le dépôt orienté de semi-conducteurs organiques, de colorants organiques, ou de particules colloïdales.

17. Utilisation selon la revendication 16, pour le dépôt orienté de pentacène.

18. Utilisation selon la revendication 16, pour le dépôt orienté de phtalocyanine de zinc.

19. Utilisation selon la revendication 16, pour le dépôt orienté du coronène.

20. Utilisation selon la revendication 16, pour le dépôt orienté de particules d'or.

## Claims

1. A process for preparing a substrate at least one surface of which is constituted by a polymer, said polymer surface being orientated and nanostructured, said process being **characterized in that** it comprises the following steps in succession:
a) brushing the polymer surface, the substrate being in an amorphous state;
b) bringing the orientated polymer surface obtained at the end of step a) into contact with a vapour of a solvent, said solvent being selected such that:
- | δ_{poly} - δₛₒₗ | / [(_{δpoly} | δₛₒₗ) / 2] < 0.3, δ_{poly} and δₛₒₗ representing the solubility parameters of the polymer and the solvent respectively; and
- γₛₒₗ < γ_{poly}, γₛₒₗ and γ_{poly} representing the free surface energies of the solvent and the polymer respectively.

2. A process according to claim 1, **characterized in that** the substrate is constituted by said polymer.

3. A process according to claim 1, **characterized in that** the substrate is constituted by a support at least one surface of which is covered with a film of polymer, said support being formed by a material that is not altered by the process for depositing the polymer film.

4. A process according to claim 3, **characterized in that** the polymer film is in the range 50 nanometres to several microns thick.

5. A process according to any one of claims 1 to 4, **characterized in that** said polymer is selected from the group comprising polyesters such as polycarbonates, fluorinated polycarbonates, polyethylene terephthalate or polyethylene naphthalate, polylactic acid, and isotactic polystyrene.

6. A process according to claim 5, **characterized in that** the polymer is bisphenol A polycarbonate.

7. A process according to claim 1, **characterized in that** the polymer is bisphenol A polycarbonate and the solvent is selected from the group constituted by acetone, toluene, chlorobenzene, tetrahydrofuran and cyclohexanone.

8. A process according to claim 1, **characterized in that** said polymer is selected from the group comprising polyesters such as polycarbonates (bisphenol A), polyethylene terephthalate and naphthalate, polylactic acid and isotactic polystyrene, and **in that** the solvent is acetone.

9. A process according to claim 1, **characterized in that** the polymer is isotactic polystyrene and the solvent is acetone.

10. A process according to claim 1, **characterized in that** it comprises a preliminary step to determine the conditions necessary to produce a given roughness of the polymer surface after step b).

11. A process according to claim 10, **characterized in that** the preliminary step comprises:
carrying out step a) for a series of identical substrates under identical conditions;
carrying out step b) for each substrate obtained at the end of step a) using the same solvent, at the same temperature, by varying the duration of the treatment from one substrate to another;
- determining the roughness produced at the surface of each substrate after step b);
- identifying the process conditions which result in the desired roughness.

12. A process according to claim 10, **characterized in that** the preliminary step comprises:
- tarrying out step a) for a series of identical substrates under identical conditions;
- carrying out step b) for each substrate obtained at the end of step a) using the same solvent, for the same duration, by varying the temperature of the treatment from one substrate to another;
- determining the roughness produced at the surface of each substrate after step b);
- identifying the process conditions which result in the desired roughness.

13. A process according to claim 11 or claim 12 **characterized in that**, after carrying out the preliminary step, steps a) and b) are carried out under the conditions identified at the end of the preliminary step.

14. A substrate constituted by a support at least one surface of which is covered with a film of polymer, said support being formed by a material that is not altered by the process for depositing the polymer film, and said surface being orientated and nanostructured, **characterized in that** said surface has a periodic structure comprising alternating amorphous zones and crystalline lamellae, the periodicity associated with a crystalline lamella/amorphous zone sequence being in the range 5 to 100 nm.

15. A substrate according to claim 14, **characterized in that** said support is a glass slide, a silicon wafer, a conductive glass or a metal surface.

16. Use of a substrate according to claim 14 or claim 15, for the orientated deposition of organic semiconductors, organic dyes or colloidal particles.

17. Use according to claim 16, for the orientated deposition of pentacene.

18. Use according to claim 16, for the orientated deposition of zinc phthalocyanine.

19. Use according to claim 16, for the orientated deposition of coronene.

20. Use according to claim 16, for the orientated deposition of gold particles.

## Patentansprüche

1. Verfahren zur Herstellung eines Substrats, wobei mindestens eine Oberfläche desselben aus einem Polymer besteht, wobei die Polymeroberfläche ausgerichtet und nanostrukturiert ist, wobei das Verfahren **dadurch gekennzeichnet ist, dass** es nacheinander die folgenden Schritte umfasst:
a) Bürsten der Polymeroberfläche, wobei sich das Substrat im amorphen Zustand befindet;
b) Inkontaktbringen der ausgerichteten Polymeroberfläche, die nach Abschluss des Schrittes a) erhalten wurde, mit einem Dampf eines Lösemittels, wobei das Lösemittel derart ausgewählt ist, dass:
- | δ_{poly} - δₛₒₗ | / [ (δ_{poly} + δₛₒₗ) / 2] < 0,3, wobei δ_{poly} und δₛₒₗ die Löslichkeitsparameter des Polymers beziehungsweise des Lösemittels darstellen, und;
- γₛₒₗ < γ_{poly}, wobei γₛₒₗ und γ_{poly} die freien Oberflächenenergien des Lösemittels und des Polymers darstellen.

2. Verfahren nach Anspruch 1, **dadurch gekennzeichnet, dass** das Substrat aus dem Polymer besteht.

3. Verfahren nach Anspruch 1, **dadurch gekennzeichnet, dass** das Substrat aus einem Träger besteht, wobei mindestens eine Oberfläche desselben mit einer Polymerdünnschicht beschichtet ist, wobei der Träger aus einem Material gebildet ist, das durch das Verfahren des Aufbringens der Polymerdünnschicht nicht beschädigt wird.

4. Verfahren nach Anspruch 3, **dadurch gekennzeichnet, dass** die Polymerdünnschicht eine Dicke im Bereich von 50 Nanometern und mehreren Mikrometern hat.

5. Verfahren nach einem beliebigen der Ansprüche 1 bis 4, **dadurch gekennzeichnet, dass** das Polymer aus der Gruppe gewählt ist, welche Polyester wie etwa Polycarbonate, fluorierte Polycarbonate, Polyethylenterephthalat und Polyethylennaphthalat, Polymilchsäure und isotaktisches Polystyrol umfasst.

6. Verfahren nach Anspruch 5, dadurch gekennze-chnet, dass es sich bei dem Polycarbonat um Bisphenol A handelt.

7. Verfahren nach Anspruch 1, **dadurch gekennzeichnet, dass** es sich bei dem Polymer um Polycarbonat handelt und das Lösemittel aus der Gruppe ausgewählt ist, welche aus Aceton, Toluol, Chlorbenzol, Tetrahydrofuran und Cyclohexanon besteht.

8. Verfahren nach Anspruch 1, **dadurch gekennzeichnet, dass** das Polymer aus der Gruppe ausgewählt ist, welche Polyester wie etwa Polycarbonate (Bisphenol A), Polyethylenterephthalat und -naphthalat, Polymilchsäure sowie isotaktisches Polystyrol umfasst, und dadurch, dass das Lösemittel Aceton ist.

9. Verfahren nach Anspruch 1, **dadurch gekennzeichnet, dass** es sich bei dem Polymer um isotaktisches Polystyrol handelt und das Lösemittel Aceton ist.

10. Verfahren nach Anspruch 1, **dadurch gekennzeichnet, dass** es einen Vorbereitungsschritt umfasst, um die Bedingungen zu bestimmen, die erforderlich sind, um nach dem Schritt b) eine gegebene Rauheit der Polymeroberfläche zu erzielen.

11. Verfahren nach Anspruch 10, **dadurch gekennzeichnet, dass** der Vorbereitungsschritt Folgendes umfasst:
- Durchführen des Schrittes a) für eine Reihe gleichartiger Substrate unter gleichartigen Bedingungen;
- Durchführen des Schrittes b) für jedes Substrat, das nach Abschluss des Schrittes a) erhalten wurde, mittels desselben Lösemittels, bei derselben Temperatur, wobei die Zeitdauer der Behandlung von einen Substrat zum anderen variiert wird;
- Bestimmen der Rauheit, die nach Schritt b) an der Oberfläche jedes Substrats erzielt wird;
- Identifizieren der Durchführungsbedingungen, die zur gewünschten Rauheit führen.

12. Verfahren nach Anspruch 10, **dadurch gekennzeichnet, dass** der Vorbereitungsschritt Folgendes umfasst:
- Durchführen des Schrittes a) für eine Reihe gleichartiger Substrate unter gleichartigen Bedingungen;
- Durchführen des Schrittes b) für jedes Substrat, das nach Abschluss des Schrittes a) erhalten wurde, mittels desselben Lösemittels, während derselben Zeitdauer, wobei die Temperatur der Behandlung von einen Substrat zum anderen variiert wird;
- Bestimmen der Rauheit, die nach Schritt b) an der Oberfläche jedes Substrats erzielt wird;
- Identifizieren der Durchführungsbedingungen, die zur gewünschten Rauheit führen.

13. Verfahren nach einem der Ansprüche 11 oder 12, **dadurch gekennzeichnet, dass** nach der Durchführung des Vorbereitungsschritts die Schritte a) und b) unter den Bedingungen durchgeführt werden, die nach Abschluss des Vorbereitungsschritts identifiziert wurden.

14. Substrat, das aus einem Träger besteht, wobei mindestens eine Oberfläche desselben mit einer Polymerdünnschicht beschichtet ist, wobei der Träger aus einem Material gebildet ist, das durch das Verfahren des Aufbringens der Polymerdünnschicht nicht beschädigt wird, und wobei die Oberfläche ausgerichtet und nanostrukturiert ist, **dadurch gekennzeichnet, dass** die Oberfläche eine periodische Struktur aufweiset, welche einen Wechsel von amorphen Bereichen und kristallinen Lamellen umfasst, wobei die Periodizität für eine Abfolge von kristalliner Lamelle / amorphem Bereich im Bereich von 5 bis 100 nm liegt.

15. Substrat nach Anspruch 14, **dadurch gekennzeichnet, dass** der Träger eine Glasplatte, ein Silizium-Wafer, ein leitfähiges Glas oder eine metallische Oberfläche ist.

16. Verwendung eines Substrats nach Anspruch 14 oder 15, um organische Halbleiter, organische Farbstoffe oder kolloidale Partikel derart aufzubringen, dass sie ausgerichtet sind.

17. Verwendung nach Anspruch 16, zum ausgerichteten Aufbringen von Pentacen.

18. Verwendung nach Anspruch 16, zum ausgerichteten Aufbringen von Zinkphthalocyanin.

19. Verwendung nach Anspruch 16, zum ausgerichteten Aufbringen von Coronen.

20. Verwendung nach Anspruch 16, zum ausgerichteten Aufbringen von Goldpartikeln.
